# EUROPEAN PATENT APPLICATION

(11) **EP 3 355 365 A1**
(43) Date of publication of application: **01.08.2018**
(21) Application number: 15904675.4
(22) Date of filing: 31.12.2015
(51) Int. Cl.: H01L 31/18

(54) **SILICON WAFER SURFACE PASSIVATION METHOD AND N-TYPE BIFACIAL CELL PREPARATION METHOD**

(30) Priority: 23.09.2015 CN 201510610013
(71) Applicant: Suzhou Talesun Solar Technologies Co., Ltd., Suzhou, Jiangsu 215542 (CN)
(72) Inventor: NI, Zhichun, Suzhou Jiangsu 215542 (CN); WEI, Qingzhu, Suzhou Jiangsu 215542 (CN); WU, Chenyang, Suzhou Jiangsu 215542 (CN); LU, Junyu, Suzhou Jiangsu 215542 (CN); LIAN, Weifei, Suzhou Jiangsu 215542 (CN)
(74) Representative: Piticco, Lorena
(86) International application number: PCT/CN2015/100165
(87) International publication number: WO 2017/049801

(57) **Abstract**

Provided are a silicon wafer surface passivation method and an N-type bifacial cell preparation method based on the silicon wafer surface passivation method. The silicon wafer surface passivation method comprises: processing a silicon wafer surface, so as to remove an oxide layer, borosilicate glass and/or phosphosilicate glass on the silicon wafer surface; in the irradiation of ultraviolet, blowing the processed silicon wafer surface by using ozone gas, so as to form silicon oxide of a first preset thickness on the processed silicon wafer surface, or soaking the silicon wafer in ozone-containing water so as to form silicon oxide of a first preset thickness on the processed silicon wafer surface. In the irradiation of ultraviolet, silicon oxide can be formed on the silicon wafer surface by blowing the silicon wafer surface by using ozone gas or soaking the silicon wafer in ozone-containing water, which can be complemented in a normal temperature, thereby greatly reducing costs; and the method is particularly suitable for large-scale industrialized production.

## Description

### CROSS REFERENCE TO RELATED APPLICATIONS

This application claims the priority of Chinese Patent Application No. 201510610013.5, filed on September 23rd, 2015, and titled with "SILICON WAFER SURFACE PASSIVATION METHOD AND N-TYPE BIFACIAL CELL PREPARATION METHOD", and the disclosures of which are hereby incorporated by reference.

### FIELD

The present disclosure relates to the field of photovoltaic solar cell, specifically to a surface passivation method for silicon wafer and a method for preparing N-type bifacial cell.

### BACKGROUND

P-type silicon cell has simple technology and low cost, taking up about 90% of the crystalline silicon cell share. Minority carrier of N-type silicon cell has long lifetime, no light degradation and high theoretical efficiency, and is considered as a leading role of the photovoltaic market in the future. There are many broken bonds on the surface of the silicon crystal. According to semiconductor theory, this kind of broken bond forms defect level in the energy level, forming recombination centre, so that decreases lifetime of minority carriers and further decreases efficiency of cells. In order to reduce surface recombination, chemical method is usually used to form chemical bonds with silicon of the surface, or thin film medium carrying fixed charges is covered to repel the "minority carrier" in silicon from reaching the interface, which is called interface passivation or field passivation.

As a main thin film material for passivation, both silicon nitride and aluminum oxide can achieve an effect of interface passivation. Therein, due to silicon nitride carries fixed positive charge and alumina carries fixed positive charge, silicon nitride repels minority carrier hole on surface of the N-type silicon wafer and alumina repels minority carrier electron on surface of the P-type silicon wafer. Therefore, field passivation effect of silicon nitride to surface of the N-type and field passivation effect of alumina to surface of the P-type are relatively good. If they are used in reverse way, the passivation film will attract minority carrier and would not give efficient passivation effect.

At present, the front surface of P-type cell produced in mass production is phosphorus doped N+ emitter plated with SiNx antireflection coating which also has the function of surface passivation. The back surface is an aluminium back surface field (aluminium at aluminium-silicon interface blends into P-type silicon), in which aluminium can be regarded as a dopant to form P+ layer, forming p-p+ high-low junction structure, which has certain passivation effect on the back surface of the cell. However, the front surface of N-type cell is boron doped P+ emitter, so the use of silicon nitride directly does not give passivation effect. Therefore, in order to improve the efficiency of the N-type cell, it is necessary to solve the problem of passivation of the P+ emitter.

Passivation materials suitable for P+ emitter include silicon oxide and aluminum oxide. Generally, silicon oxide is deposited by thermal oxidation method or CVD chemical deposition, and aluminum oxide is prepared by methods such as atomic layer deposition (ALD) and plasma enhanced chemical vapour deposition (PECVD). Thermal oxidation is a high temperature process, which generally requires temperature ranging from 900 to 1000°C. The high temperature process prolongs process time of cell and reduces bulk lifetime of silicon, which not only reduces the efficiency of cell, but also decrease the productivity and increases the cost. ALD and PECVD belong to epitaxial growth. Although they give good passivation effect, the requirements for the cleanliness of the interface are really high. In actual production process, silicon wafer is transferred between processes and is easy to be polluted, resulting in the fluctuation of passivation quality. In addition, the cost of introducing new equipment is really high, making it not suitable for large-scale production.

### SUMMARY

In view of above, the first aspect of the present disclosure provides a surface passivation method for silicon wafer, so as to overcome the disadvantages of surface passivation method for silicon wafer in the prior art.

On the base of the first aspect of the present disclosure, the second aspect of the present disclosure provides a method for preparing an N-type bifacial cell.

In order to achieve the goals of the disclosure, the present disclosure employs technical solutions as follows:

A method for passivating the surface of a silicon wafer, comprising:
processing the surface of the silicon wafer to remove oxide layer, borosilicate glass and/or phosphosilicate glass from the surface of the silicon wafer;
blowing ozone gas to the processed surface of the silicon wafer under irradiation of ultraviolet to form silicon oxide with a first preset thickness on the processed surface of the silicon wafer, or immersing the silicon wafer in ozone-containing water to form silicon oxide with the first preset thickness on the processed surface of the silicon wafer.

Optionally, if blowing ozone gas under ultraviolet irradiation is performed to form the silicon oxide with the first preset thickness on the processed surface of the silicon wafer, the first preset thickness is controlled by the duration of the exposure of the silicon wafer to ozone and the intensity of ultraviolet irradiation.

Optionally, the first preset thickness is between 1 and 5nm inclusively.

Optionally, the surface of the silicon wafer is processed to remove oxide layer, borosilicate glass and/or phosphosilicate glass, comprising:
Step A: processing the surface of the silicon wafer with a HF solution or a first mixed acid solution containing HF to remove oxide layer, borosilicate glass and/or phosphosilicate glass;
Step B: neutralizing the acid solution remaining on the surface of the silicon wafer by using an alkaline solution;
Step C: removing the alkaline solution and metal impurities remaining on the surface of the silicon wafer.

Optionally, the mass concentration of HF is 2 to 10% in the HF solution and/or in the first mixed acid solution.

Optionally, the first mixed acid solution consists of HF solution and at least one acid solution selected from the group consisting of HCl, HNO₃, and H₂SO₄.

Optionally, the Step C comprises: removing the alkaline solution and the metal impurities remaining on the surface of the silicon wafer by using a second mixed acid solution containing HF; wherein the mass concentration of HF is ≤ 10% in the second mixed acid solution.

Optionally, a chain or tank cleaning device is used in Step A.

Optionally, between the Step A and the Step B, the Step B and the Step C, and/or after the Step C, the method further comprises:
washing or rinsing the surface of the silicon wafer by using deionized water.

A method for preparing an N-type bifacial cell, comprising:
processing the front surface and the back surface of a silicon wafer respectively to remove surface damage and anisotropic etching;
subjecting boron diffusion to the front surface of the processed silicon wafer to form borosilicate glass on the front surface of the processed silicon wafer;
removing oxide layer from the back surface of the processed silicon wafer;
forming a silicon nitride mask on the surface of the borosilicate glass;
subjecting phosphorus diffusion to the back surface of the silicon wafer, from which the oxide layer is removed, to form phosphosilicate glass on the back surface of the processed silicon wafer;
removing the silicon nitride mask, the borosilicate glass and the phosphosilicate glass;
forming a silicon oxide film respectively on the front surface and the back surface of the silicon wafer, by using the method according to any one of claims 1 to 9;
forming a silicon nitride layer with a second preset thickness respectively on the silicon oxide film formed on the front surface and the back surface of the silicon wafer;
printing silver paste on the silicon nitride layer formed on the front surface and the back surface of the silicon wafer, drying and sintering to form an electrode.

Optionally, the process condition for subjecting the boron diffusion to the front surface of the processed silicon wafer is: diffusion temperature of from 850 to 1100°C, diffusion time of from 45 to 120min, and diffusion square resistance of from 40 to 100Ω.

Optionally, the process condition for subjecting the phosphorus diffusion to the back surface of the silicon wafer, from which the oxide layer is removed, is: diffusion temperature of from 800 to 900°C, diffusion time of from 30 to 120min, and diffusion square resistance of from 20 to 60Ω.

Optionally, the second preset thickness is from 70 to 90nm inclusively.

Comparing with the prior art, the present disclosure has beneficial effects as follows:

In the surface passivation method of silicon wafer provided by the present disclosure, silicon oxide can be formed on the surface of the silicon wafer by blowing the ozone gas to the surface of the silicon wafer under the ultraviolet irradiation, or by immersing the silicon wafer in ozone-containing water. This step can be accomplished at normal temperature, thereby greatly reducing costs, being particularly suitable for large-scale industrial production. In addition, the N-type bifacial cell based on the method overcomes defects caused by thermal oxidation and atomic layer deposition generation, ensuring passivation quality of the N-type bifacial cell.

### BRIEF DESCRIPTION OF DRAWINGS

For a clear understanding of the specific embodiments of the present disclosure, a brief description of the drawings used in the description of the specific embodiments of the present invention will be given hereinafter.
Figure 1 is a flow chart of the surface passivation method of silicon wafer provided by an example of the present disclosure.
Figure 2 is a flow chart of a specific implementation of S11 provided by an example of the present disclosure.
Figure 3 is a flow chart of the method for preparing an N-type bifacial cell provided by an example of the present disclosure.

### DETAILED DESCRIPTION

In order to make the purpose, technical means, and technical effects of the present disclosure more clear and complete, the examples of the present disclosure will be described in detail in conjunction with the accompanying drawings hereinafter.

### Example 1

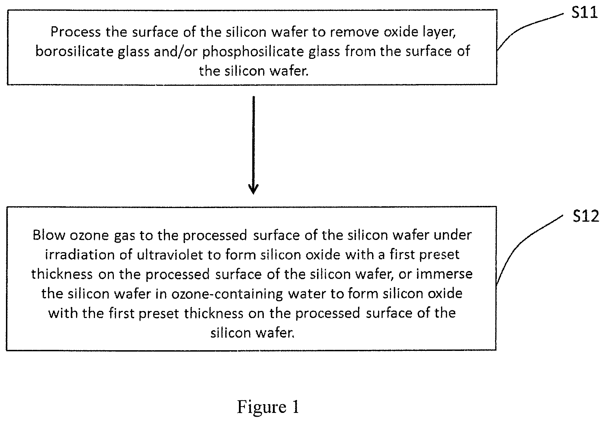

Figure 1 is flow chart of the method for passivating the surface of a silicon wafer provided by Example 1 of the present disclosure. As shown in Figure 1, the method comprises:

S11. Process the surface of the silicon wafer to remove oxide layer, borosilicate glass and/or phosphosilicate glass from the surface of the silicon wafer.

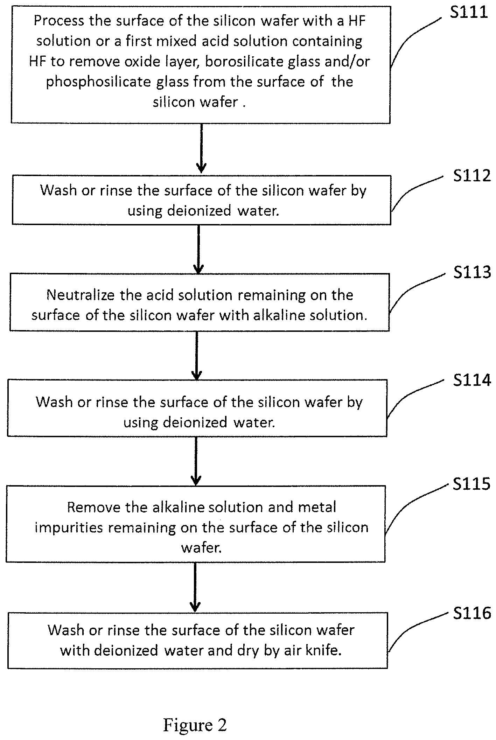

It should be noted that conventional technical means in the art can be used to process the surface of the silicon surface to remove the oxide layer, borosilicate glass and/or phosphosilicate glass on the surface of the silicon wafer. As an example, a specific implementation of the Step 11 is shown in Figure 2, comprising:

S111. Process the surface of the silicon wafer with a HF solution or a first mixed acid solution containing HF to remove the oxide layer, borosilicate glass and/or phosphosilicate glass.

It should be noted that, in the example of the present disclosure, the mass concentration of HF (hydrofluoric acid) solution and/or the mass concentration of HF in the first mixed acid solution can be from 2 to 10%.

Therein, the first mixed acid solution is a mixture of HF acid and other acid, wherein other acid is at least one acid solution selected from HCl (hydrochloric acid), HNO₃ (nitric acid), H2SO4 (sulphuric acid). That is, the first mixed acid solution consists of HF solution and at least one acid solution selected from HCl, HNO₃, H₂SO₄ solution.

It should be noted that in the first mixed acid solution, the mass concentration of other acids can be defined according to practical need without being too high.

S112. Wash or rinse the surface of the silicon wafer by using deionized water.

It should be noted that this step is to wash or rinse away the acid solution remaining on the surface of the silicon wafer.

S113. Neutralize the acid solution remaining on the surface of the silicon wafer with alkaline solution.

If only the deionized water is used to wash or rinse the surface of the silicon wafer, the acid solution remaining on the surface of the silicon wafer may not be completely removed. Therefore, an alkaline solution can be further used to neutralize the acid solution remaining on the surface of the silicon wafer. It should be noted that in this step, except for neutralizing the acid solution remaining on the surface of the silicon wafer, the alkaline solution can also smooth the surface of the silicon wafer.

As an example, the alkaline solution used in this step can be NaOH solution of 5 to 10% or KOH solution.

S114. Wash or rinse the surface of the silicon wafer by using deionized water.

It should be noted that this step is to wash or rinse away the alkaline solution remaining on the surface of the silicon wafer.

S115. Remove the alkaline solution and metal impurities remaining on the surface of the silicon wafer.

As a specific example of the present disclosure, in this step, an acid solution can be used to remove the alkaline solution and metal impurities remaining on the surface of the silicon wafer.'

Optionally, the acid solution used in this step can be a second mixed acid solution containing HF. The second mixed acid solution can consist of HF and HCl, wherein the mass concentration of the HF is generally not more than 10%.

S116. Wash or rinse the surface of the silicon wafer with deionized water and dry by air knife.

In addition, as another specific example of the present disclosure, the equipment used in the S11 can be a chain cleaning equipment or a tank cleaning equipment.

S12. Blow ozone gas to the processed surface of the silicon wafer under ultraviolet irradiation to form silicon oxide with a first preset thickness on the processed surface of the silicon wafer, or immerse the silicon wafer in ozone-containing water to form silicon oxide with the first preset thickness on the processed surface of the silicon wafer.

When blowing ozone gas to the surface of the processed silicon wafer to form silicon oxide with the first preset thickness on the surface of the processed silicon wafer under ultraviolet irradiation, the specific steps are: placing the silicon wafer in the chain cleaning equipment; under irradiation of ultraviolet, blowing ozone gas to the surface of the silicon wafer; forming silicon oxide with the first preset thickness on the surface of the silicon wafer. At this point, the first preset thickness d of the silicon oxide can be controlled by contact time of ozone and silicon wafer and the intensity of ultraviolet irradiation.

As an example, the specific controlling process can be as follows: adjusting the angle of the air knife and the rotation speed of conveyor chain in the chain cleaning equipment to control the contact time of ozone and the silicon wafer, generally 1 to 2min; range of the thickness d is preferred between 1 to 5nm, including endpoints.

Therefore, by using this method, silicon oxide can be formed on the surface of the silicon wafer by blowing ozone gas to the surface of the silicon wafer or immersing the silicon wafer in the ozone-containing water under ultraviolet irradiation. This step can be accomplished at room temperature, thereby greatly reducing costs, being particularly suitable for large-scale industrial production. The silicon oxide formed by this method can be used as passivation film on the surface of P+ crystal silicon cell, solving the problem of front surface passivation of N-type cell.

In addition, when the silicon wafer is immersed in the ozone-containing water to form silicon oxide with a first preset thickness on the processed silicon wafer, the specific steps are:

immersing the silicon wafer in the ozone-containing water by using the ozone-containing water in a tank cleaning equipment. At this point, ozone reacts with silicon on the surface of the silicon wafer, forming a silicon oxide film. After the silicon wafer is immersed in the ozone-containing water for a certain time, silicon oxide with the first preset thickness is formed on the surface of the processed silicon wafer. The thickness of the silicon oxide formed can be controlled by the immersing time.

The above is a specific example of a method for passivating the surface of a silicon wafer provided by the present disclosure. In this example, silicon oxide can be formed on surface of the silicon wafer only by blowing ozone gas to the surface of the silicon wafer or immersing the silicon wafer in the ozone-containing water. This step can be accomplished at room temperature, reducing the cost dramatically, being particularly suitable for large-scale industrial production. In addition, the N-type bifacial cell based on the method overcomes defects caused by thermal oxidation and atomic layer deposition generation, ensuring passivation quality of the N-type bifacial cell.

Based on the method for passivating the surface of a silicon wafer provided by the example above, the present disclosure also provides a method for preparing N-type bifacial cell, and detailed reference is made to Example 2.

### Example 2

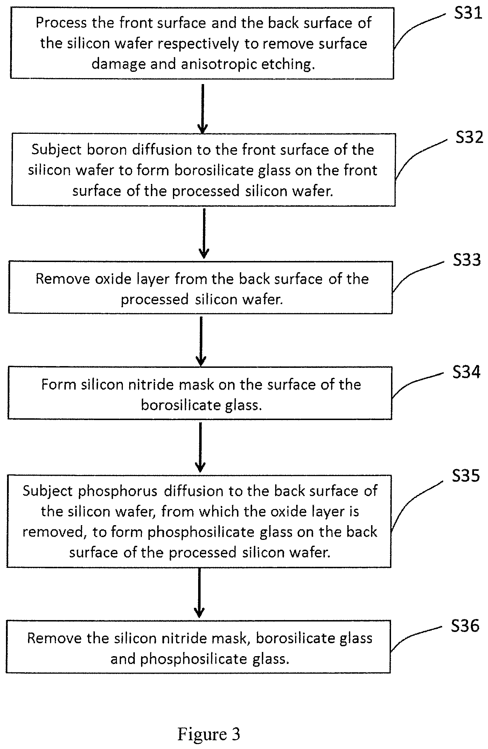

Figure 3 is the flow chart of the method for preparing N-type bifacial cell provided by Example 2 of the present disclosure. As shown in Figure 3, the method comprises the following steps:

S31. Process the front surface and the back surface of the silicon wafer respectively to remove surface damage and anisotropic etching.

NaOH solution or KOH solution is used to treat the front surface and the back surface of the silicon wafer, respectively, to remove the surface damage and anisotropic etching from the surface of the silicon wafer.

S32. Subject boron diffusion to the front surface of the silicon wafer to form borosilicate glass on the front surface of the processed silicon wafer.

The step specifically is: coating boron paste on the processed silicon wafer and drying; annealing in tube furnace to complete the boron diffusion so as to form borosilicate glass on the front surface of the processed silicon wafer.

Therein, when coating the paste, spin coating equipment can be used to coat the boron paste on the front surface of the silicon wafer, so that the boron paste is evenly coated on the front surface of the silicon wafer.

The process condition for subjecting the boron diffusion on the front surface of the processed silicon is: diffusion temperature of from 850 to 1100°C, diffusion time of from 45 to 120min, and diffusion square resistance of from 40 to 100Ω.

S33. Remove oxide layer from the back surface of the processed silicon wafer.

This step specifically is: washing away the oxide layer on the back surface of the silicon wafer with HF in a water jet single-sided etching machine.

S34. Form silicon nitride mask on the surface of the borosilicate glass.

This step specifically is: forming a silicon nitride mask with a thickness of 20 to 60nm by APCVD (Atmospheric Pressure Chemical Vapour Deposition) method on the borosilicate glass, that is, surface of the diffusion boron,.

S35. Subject phosphorus diffusion to the back surface of the silicon wafer, from which the oxide layer is removed, to form phosphosilicate glass on the back surface of the processed silicon wafer.

The silicon wafer is placed in the phosphorus diffusion tube, and phosphorus diffusion is carried out on the back surface of the silicon wafer, of which the oxide layer is removed, to form phosphosilicate glass on the back surface of the processed silicon wafer.

Therein, the process condition for subjecting the phosphorus diffusion to the back surface of the silicon wafer, from which the oxide layer is removed, is: diffusion temperature of from 800 to 900°C, diffusion time of from 30 to 120min, and diffusion square resistance of from 20 to 60Ω.

S36. Remove the silicon nitride mask, borosilicate glass and phosphosilicate glass.

This step specifically is: removing the silicon nitride mask of the silicon wafer by hot phosphoric acid; washing away the phosphosilicate glass and the borosilicate glass by the chain cleaning equipment.

S37. Form a silicon oxide film respectively on the front surface and back surface of the silicon wafer by the method of Example 1.

Therein, the thickness of the silicon oxide film is between 1 to 5nm inclusively.

S38. Form a silicon nitride layer with a second preset thickness respectively on the silicon oxide film on front surface and back surface of the silicon wafer:

This step specifically is: forming a silicon nitride layer with the second preset thickness on the silicon oxide film on the front surface and back surface of the silicon wafer by using PECVD method. Therein, the second preset thickness is 70 to 90nm, including endpoints.

S39. Print silver paste on the silicon nitride layer formed on the front surface and back surface of the silicon wafer; dry and sinter the silicon wafer to form an electrode.

The above is the example of method for preparing N-type bifacial cell provided by the present disclosure. The method overcomes defects caused by thermal oxidation and atomic layer deposition generation of silicon oxide film, ensuring the passivation quality of the N-type bifacial cell.

The examples above merely aim to illustrate the technical concept and characteristics of the present disclosure, and the purpose of the embodiments is to allow the person skilled in the art to understand the contents of the present disclosure and implements them according to the present disclosure, and does not limit the protection scope of the present invention. Equivalent changes or modifications made in spirit are to be covered by the protection scope of the present invention.

## Claims

1. A method for passivating the surface of a silicon wafer, comprising:
processing the surface of the silicon wafer to remove oxide layer, borosilicate glass and/or phosphosilicate glass from the surface of the silicon wafer;
blowing ozone gas to the processed surface of the silicon wafer under irradiation of ultraviolet to form silicon oxide with a first preset thickness on the processed surface of the silicon wafer, or immersing the silicon wafer in ozone-containing water to form silicon oxide with the first preset thickness on the processed surface of the silicon wafer.

2. The method according to claim 1, wherein if blowing ozone gas under ultraviolet irradiation is performed to form the silicon oxide with the first preset thickness on the processed surface of the silicon wafer, the first preset thickness is controlled by the duration of the exposure of the silicon wafer to ozone and the intensity of ultraviolet irradiation.

3. The method according to claim 1 or 2, wherein the first preset thickness is between 1 and 5nm inclusively.

4. The method according to claim 1 or 2, wherein the processing of the surface of the silicon wafer to remove oxide layer, borosilicate glass and/or phosphosilicate glass comprises:
Step A: processing the surface of the silicon wafer with a HF solution or a first mixed acid solution containing HF to remove oxide layer, borosilicate glass and/or phosphosilicate glass;
Step B: neutralizing the acid solution remaining on the surface of the silicon wafer by using an alkaline solution;
Step C: removing the alkaline solution and metal impurities remaining on the surface of the silicon wafer.

5. The method according to claim 4, wherein the mass concentration of HF is 2 to 10% in the HF solution and/or in the first mixed acid solution.

6. The method according to claim 4, wherein the first mixed acid solution consists of HF solution and at least one acid solution selected from the group consisting of HCl, HNO₃, and H₂SO₄.

7. The method according to claim 4, wherein Step C is performed by:
removing the alkaline solution and the metal impurities remaining on the surface of the silicon wafer by using a second mixed acid solution containing HF; wherein the mass concentration of HF is ≤10% in the second mixed acid solution.

8. The method according to claim 4, wherein a chain or tank cleaning device is used in Step A.

9. The method according to claim 4, further comprising, between Step A and Step B, between Step B and Step C, and/or after Step C,
washing or rinsing the surface of the silicon wafer by using deionized water.

10. A method for producing an N-type bifacial cell, comprising:
processing the front surface and the back surface of a silicon wafer respectively to remove surface damage and anisotropic etching;
subjecting boron diffusion to the front surface of the processed silicon wafer to form borosilicate glass on the front surface of the processed silicon wafer;
removing oxide layer from the back surface of the processed silicon wafer;
forming a silicon nitride mask on the surface of the borosilicate glass;
subjecting phosphorus diffusion to the back surface of the silicon wafer, from which the oxide layer is removed, to form phosphosilicate glass on the back surface of the processed silicon wafer;
removing the silicon nitride mask, the borosilicate glass and the phosphosilicate glass;
forming a silicon oxide film respectively on the front surface and the back surface of the silicon wafer, by using the method according to any one of claims 1 to 9;
forming a silicon nitride layer with a second preset thickness respectively on the silicon oxide film formed on the front surface and the back surface of the silicon wafer;
printing silver paste on the silicon nitride layer formed on the front surface and the back surface of the silicon wafer, drying and sintering to form an electrode.

11. The method according to claim 10, wherein the process condition for subjecting the boron diffusion to the front surface of the processed silicon wafer is: diffusion temperature of from 850 to 1100°C, diffusion time of from 45 to 120min, and diffusion square resistance of from 40 to 100Ω.

12. The method according to claim 10, wherein the process condition for subjecting the phosphorus diffusion to the back surface of the silicon wafer, from which the oxide layer is removed, is: diffusion temperature of from 800 to 900°C, diffusion time of from 30 to 120min, and diffusion square resistance of from 20 to 60Ω.

13. The method according to claim 10, wherein the second preset thickness is from 70 to 90nm inclusively.
